# FASCICULE DE BREVET EUROPEEN

(11) **EP 2 485 243 B1**
(45) Date de publication et mention de la délivrance du brevet: **14.03.2018**
(21) Numéro de dépôt: 12153896.1
(22) Date de dépôt: 03.02.2012
(51) Int. Cl.: H01J 49/40, B81B 7/02

(54) **Micro-réflectron pour spectromètre de masse à temps de vol**
Mikro-Reflektron für Flugzeit-Massenspektrometer
Micro-reflectron for time-of-flight mass spectrometry

(30) Priorité: 07.02.2011 FR 1150971
(43) Date de publication de la demande: 08.08.2012
(73) Titulaire: Commissariat à l'Énergie Atomique et aux Énergies Alternatives, 75015 Paris (FR)
(72) Inventeur: Danel, Jean-Sébastien, 38130 ECHIROLLES (FR); Duraffourg, Laurent, 38500 VOIRON (FR); Progent, Frédéric, 75005 PARIS (FR); Tassetti, Charles-Marie, 75020 PARIS (FR)
(74) Mandataire: Santarelli

(56) Documents cités:
- US-A- 5 814 813
- US-A1- 2006 071 161
- US-A1- 2010 090 098
- US-B2- 7 605 377
- P. A. ROMAN ET AL: "A miniature MEMS and NEMS enabled time-of-flight mass spectrometer for investigations in planetary science", PROCEEDINGS OF SPIE, vol. 6959, 1 janvier 2008 (2008-01-01), pages 69590G-69590G-13, XP055008935, ISSN: 0277-786X, DOI: 10.1117/12.777670
- TODD T. KING ET AL: "Simulation of a miniature, low-power time-of-flight mass spectrometer for in situ analysis of planetary atmospheres", PROCEEDINGS OF SPIE, vol. 6959, 1 janvier 2008 (2008-01-01), pages 69590E-69590E-15, XP055008941, ISSN: 0277-786X, DOI: 10.1117/12.780113

## Description

L'invention concerne un micro-réflectron, réalisé par micro-fabrication, utilisé dans un spectromètre de masse à temps de vol ou dans un autre appareil, ainsi qu'un ensemble comportant un tel micro-réflectron. Elle s'applique en premier lieu à l'analyse chimique au sens large, appliquée aux besoins de l'industrie, aux questions de sécurité ou à la surveillance environnementale notamment.

De manière générale, de nombreuses techniques d'analyse chimique permettant de séparer les espèces constitutives d'un mélange en fonction de diverses propriétés (taille, masse, propriétés chimiques...) sont disponibles. Parmi ces technologies, la spectrométrie de masse permet de séparer les espèces en fonction de leur masse. Pour ce faire, il est procédé à l'ionisation du mélange à analyser ce qui permet ensuite de séparer les différents composés en fonction de leur rapport masse sur charge. Les espèces ionisées sont injectées avec une certaine vitesse dans un champ électromagnétique qui peut être fixe ou variable au cours du temps et dans l'espace. Les forces qui s'exercent sur les ions modifient alors leur trajectoire en fonction du rapport masse sur charge de ceux-ci. Cela peut entraîner une séparation spatiale ou temporelle des différentes espèces chimiques.

Plus particulièrement, le principe d'un spectromètre de masse à temps de vol, c'est-à-dire identifiant les composés chimiques en fonction de la mesure d'un temps de parcours spécifique de chaque espèce, est connu depuis les années 1950. Le premier dispositif de ce genre a été décrit par W. Stephens dans le brevet US - 2 847 576.

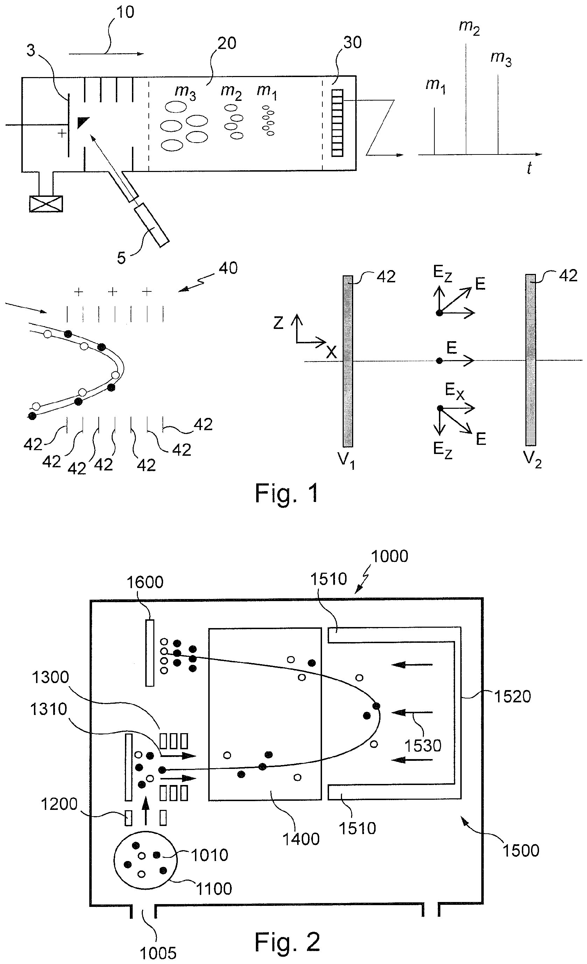

En référence à la figure 1, qui est un schéma de principe, les différentes espèces ioniques m1, m2 et m3 sont accélérées par un champ électrostatique 10 puis injectées dans une zone de vol libre 20 (ou tube de vol, dont la longueur peut être de 1 m dans certains dispositifs), c'est-à-dire une zone sans champ où les ions s'éloignent les uns des autres (« zone de drift ») en fonction de leur rapport masse sur charge. Les masses les plus légères (m1) arrivent sur le détecteur 30 placé à la sortie de cette zone de vol libre 20 avant les masses les plus lourdes (m2, m3).

La mesure du temps de vol donne ainsi la valeur de la masse, comme cela apparaît à droite de la figure.

L'ionisation préalable, qui a lieu dans une source 3, peut être effectuée par désorption-ionisation à l'aide d'un laser 5, mais d'autres techniques d'ionisation existent.

Différentes techniques permettant d'augmenter sensiblement les performances de ce type de spectromètre ont été développées. Elles concernent par exemple la modification de l'architecture du dispositif, et l'ajout d'éléments corrigeant les dispersions.

Ainsi, un miroir électrostatique 40, appelé réflectron, est présent dans certains spectromètres de masse à un endroit ou un autre de la zone de vol. Un tel miroir 40, représenté sur la partie basse de la figure 1, met en oeuvre un champ électrique statique pour modifier la direction des trajectoires des particules chargées. Il est classiquement composé d'une série d'électrodes discrètes 42 isolées les unes des autres et sur lesquelles des potentiels électrostatiques décroissants d'une électrode à l'autre sont appliqués, créant ainsi un gradient de potentiel le long de la trajectoire des ions.

Ce miroir 40 est nécessaire à l'obtention d'une bonne résolution, notamment pour les dispositifs de petites dimensions dans lesquels les dispersions temporelles et spatiales ne peuvent pas être négligées.

Il permet d'une part de compenser la dispersion spatiale des ions liée à l'étendue géométrique de la source d'ions 3. Des ions de même masse peuvent en effet être générés à différents endroits de la source 3 ce qui cause une dispersion temporelle aléatoire diminuant la résolution du système.

Le miroir 40 permet d'autre part à des ions dotés du même rapport masse sur charge, mais d'énergies cinétiques différentes d'arriver au détecteur 30 en même temps. Il existe une position, en aval du réflectron 40 où la pénalité en temps imposée aux ions les plus énergétiques compense exactement l'avantage que ceux-ci avaient initialement sur les ions moins énergétiques. C'est à ce plan de focalisation temporelle des ions de même rapport m/z que l'on place le détecteur 30 (non représenté en cette partie basse de la figure 1).

De plus en plus de domaines, notamment la surveillance de l'environnement, la sécurité civile et les industries chimiques et pétrochimiques, ont des besoins croissants de pouvoir réaliser des mesures d'analyse de l'environnement sur sites, en temps réel et avec de fortes exigences en terme de performances. Les spectromètres de masse seraient un moyen de mesure intéressant pour répondre à ce besoin d'analyse, mais les dispositifs actuels sont, soit des objets de laboratoires volumineux et chers, soit des outils portables, rarement autonomes, aux performances dégradées.

Différents problèmes sont rencontrés dans la voie de la miniaturisation des spectromètres de masse. D'une part, il est nécessaire de développer des techniques de fabrication des éléments spécifiques du spectromètre fiables et qui ne soient pas trop onéreuses. D'autre part, il est nécessaire de disposer d'une technique d'acquisition des signaux récoltés à la sortie du dispositif compatible avec le caractère miniature des distances, des temps de parcours et éventuellement des quantités de matériau injectées dans l'appareil. Enfin, il est nécessaire de développer des solutions à des problèmes rencontrés spécifiquement aux échelles micrométriques, notamment en matière de distorsion des champs électromagnétiques.

En ce qui concerne les procédés de fabrication, des équipes travaillent sur la miniaturisation des spectromètres de masse en utilisant les technologies MEMS (acronyme anglo-saxon de systèmes micro-électromécaniques « MicroElectroMechanical Systems »). Ces techniques ont permis l'émergence d'un nouveau type de composants miniatures, tels des capteurs, des actionneurs, ou des sources d'énergie.

Des brevets et articles scientifiques ont été publiés ces dernières années sur des pièges ioniques, des filtres quadripolaires ou des filtres magnétiques miniatures, dont certains ont ainsi été fabriqués en technologie MEMS. Des brevets significatifs dans le domaine portent les numéros US - 7 402 799, US - 6 967 326, US - 6 469 298 (correspondant à EP - 1 218 921), US - 7 208 729 et US - 7 217 920. L'article 'Complex MEMS : a fully integrated TOF micro mass spectrometer » de Eric Wapelhorst et al., paru dans Sensors and Actuators, A 138 (2007) pp 22-27 présente quant à lui un spectromètre de masse en technologie MEMS comprenant un filtre temporel monochromatique ne recherchant qu'une seule espèce ionique. Le spectre complet des espèces chimiques présentes est obtenu en appliquant une rampe de tension sur le filtre temporel. De multiples injections sont donc nécessaires ce qui nécessite un temps important. Le document « Fabrication of a novel micro time-of-flight mass spectrometer » de H J Yoon et al., paru dans Sensors and Actuators, A 97-98, (2002), pp 41-447 présente enfin un spectromètre de masse en technologie MEMS à temps de vol rudimentaire, dont la très faible résolution ne lui permet que de distinguer des ions de très petites masses. Notamment, il est remarquable que ce spectromètre ne comprend pas de réflectron, dont la mise au point à petite échelle est d'une difficulté importante.

Les articles « A miniature MEMS and NEMS enabled Time-of-Flight Mass Spectrometer for Investigations in Planetary Science » de Roman et al, paru dans Proceedings of SPIE, Vol 6959, 1er janvier 2008, pages 69590G1-G13 et "Simulation of a Miniature, Low-Power Time-of-Flight Mass Spectrometer for In Situ Analysis of Planetary Atmosphères" de King et al (il s'agit sensiblement des mêmes auteurs que pour l'article précédent, mais dans un ordre différent), paru dans Proceedings of SPIE, Vol 6959, 1er janvier 2008, pages 69590E1à E15, décrivent des spectromètres qui, bien qu'ils comportent des éléments de petite taille de type MEMS, impliquent un assemblage complexe de diverses pièces aboutissant à un ensemble dont les dimensions ne sont pas dans le domaine micrométrique, puisque le prototype qui est décrit a des dimensions de 5 cm de hauteur, de 10 cm de largeur, et de 30 cm de longueur ; cette grande longueur est due notamment à la chambre de temps de vol.

Par ailleurs, en ce qui concerne les systèmes électroniques d'acquisition de signaux, les progrès effectués ces dernières années ont abouti à la commercialisation d'appareils portables permettant l'échantillonnage de signaux à plusieurs dizaines de milliards d'échantillons par seconde pour une bande passante de plusieurs dizaines de GHz.

Dans le cadre d'un spectromètre de masse de type à temps de vol, pour lequel la miniaturisation amène à prévoir des différences de temps de vol entre particules de masses voisines inférieures à la nanoseconde, ces systèmes d'échantillonnage de nouvelles générations rendent possible une mesure fiable des signaux, pour autant qu'une séparation efficace ait été effectuée.

Au final, bien que des progrès aient été réalisés dans les techniques de fabrication des composantes spécifiques de spectromètre et dans les dispositifs d'acquisition numérique, les systèmes qui ont été présentés ont une étendue d'analyse qui reste faible et également une résolution m/Δm limitée (m étant la masse de l'ion à laquelle la résolution est exprimée, Δm la différence de masse minimale mesurable au rang de masse m), de l'ordre de 10 à 50 pour des ions ayant une masse de seulement une centaine d'unités de masse atomique.

Ainsi, l'analyse est limitée aux composés chimiques de faible masse et la résolution et la sensibilité sont faibles. De plus, les dispositifs sont peu robustes.

Le brevet US - 7 605 377 décrit un réflectron à électrodes discrètes qui est miniature, pouvant être utilisé dans un spectromètre de masse à temps de vol. Il comprend un substrat, à la surface duquel sont présentes les électrodes individuellement accrochées par des connecteurs formés dans le substrat ou couplés à celui-ci.

Néanmoins, dans un tel dispositif, la diminution du rapport entre les dimensions des électrodes discrètes, y compris la distance qui les sépare les unes des autres, et le diamètre du faisceau d'ions, a pour conséquence que la déformation du champ électrique dans les zones latérales du réflectron affecte le faisceau d'ions.

En effet, comme cela est schématisé sur la partie inférieure à droite de la figure 1, le champ électrique n'est pas uniforme dans l'espace compris entre deux électrodes. Ce défaut d'uniformité est maintenu quand les dimensions linéaires du réflectron sont modifiées (on précise quand dans cette hypothèse, les différences de potentiel entre les électrodes sont modifiées de manière à conserver un gradient de potentiel constant).

Comme le diamètre du faisceau d'ions n'est pas modifié, il en résulte que le défaut d'uniformité du champ qui était sans conséquence dans un dispositif macroscopique devient un inconvénient majeur dans un dispositif microscopique. La composante de champ électrique suivant la direction Z attire les ions dans la direction Z, et fait donc diverger le faisceau ionique. Les ions qui ont trop divergé de leur trajectoire percutent les électrodes du réflectron et sont par conséquent perdus pour l'analyse.

Ce problème complique singulièrement la conception d'un spectromètre de masse de type temps de vol de petite taille, qui ait une résolution et une sensibilité satisfaisantes, incorporant un réflectron de ce type à électrodes discrètes.

Une lentille réflectron est connue pour des spectromètres classiques de grande taille utilisés en laboratoire et est décrite dans les brevets US -7 154 086 et US - 2010/0090098. Ce dispositif est constitué d'un tube en verre ou un tube dans un autre matériau sur lequel une couche de verre est déposée, maintenu par une unique extrémité au fond d'un tube de vol du spectromètre. Un tel dispositif utilisant une lentille qui est maintenue à une unique extrémité n'est pas compatible avec l'utilisation d'un substrat à la surface duquel sont présentes les électrodes individuellement accrochées par des connecteurs formés dans le substrat ou couplés à celui-ci, par exemple par empilement.

Un tel dispositif utilisant une lentille n'est pas non plus compatible avec un support ayant une fonction de soutien mécanique pour la manipulation du dispositif par un utilisateur dans le volume duquel le réflectron est intégré, par exemple par empilement. De plus, les techniques de fabrication, les géométries et les matériaux employés ne sont pas compatibles avec les procédés de micro-fabrication de l'industrie micro-électronique. Il est donc nécessaire de développer une autre technologie de fabrication pour cet élément indispensable à la mise au point d'un micro-spectromètre de masse.

L'invention décrite ci-après résout ces problèmes et permet de disposer d'un micro-réflectron utilisable dans un micro-spectromètre de masse portable, autonome et performant, à coût maîtrisé.

Ainsi l'invention propose un micro-réflectron, réalisé par les techniques de micro-fabrication, et utilisable dans un spectromètre de masse à temps de vol qui peut être de petite taille. L'invention propose un micro-réflectron selon la revendication 1 et un procédé de fabrication d'un tel micro-réflectron selon la revendication 15.

Plus précisément l'invention propose un micro-réflectron pour spectromètre de masse à temps d vol, comprenant un substrat et, intégrés au volume du substrat (par exemple par empilement), des moyens d'application d'un gradient de potentiel dans un volume adapté à constituer une zone de vol des ions, caractérisé en ce que lesdits moyens d'application comprennent au moins deux électrodes de polarisation et une paroi en au moins un matériau résistif adaptée à être polarisée entre ces électrodes en sorte de générer un gradient continu de potentiel en assurant elle-même la fonction de réflectron ; ce micro-réflectron, en particulier la zone de vol, ces électrodes et cette paroi sont obtenues par la technologie des systèmes micro-électromécaniques (MEMS) et ce micro-réflectron a une épaisseur inférieure à 5 millimètres tandis que ses autres dimensions sont inférieures à 10 fois cette épaisseur.

Le terme « micro- », s'agissant du réflectron, indique qu'au moins une de ses dimensions, par exemple l'épaisseur mesurée depuis l'extérieur du substrat jusqu'à l'extérieur du dispositif à l'opposé du substrat, est inférieure à environ 1 mm, ou en tout cas environ 5 mm. Les deux autres dimensions, dans lesquelles la trajectoire des ions est amenée à s'inscrire, peuvent être chacune supérieure à l'épaisseur d'un facteur 10 (ou moins). Selon une définition alternative, le terme « micro-» indique que le réflectron est fabriqué selon les technologies de la micro-électronique.

Il est rappelé que la technologie des systèmes micro-électromécaniques regroupe des procédés de la micro-électronique (au sens large du terme incluant des aspects mécaniques) incluant diverses formes de gravure, de dépôt, de lithographie et d'assemblage/empilement qui sont bien connues et maitrisées par l'homme de métier. Ainsi, le fait que la structure du micro-réflectron est obtenue par une telle technologie précise significativement cette structure dans laquelle on reconnaît aisément que cette technologie a été utilisée. On comprend que le fait qu'un tel micro-réflectron soit réalisé sur un substrat par une telle technique offre notamment l'avantage de permettre que d'autres éléments d'un spectromètre puissent être réalisés par la même technologie sur ce même substrat.

Ainsi, les électrodes discrètes connues dans les réflectrons classiques (il ressort de ce qui précède qu'aucun d'entre eux n'est vraiment un « micro-réflectron ») sont remplacées par une paroi résistive dans laquelle se développe un gradient continu de potentiel qui assure un champ homogène dans la zone de vol des ions servant de réflectron malgré la petite taille de ce dernier.

Selon une caractéristique avantageuse, ladite paroi comprend au moins une couche en matériau résistif déposée sur une surface d'un volume de matériau de substrat. Cette caractéristique permet d'éviter une consommation électrique trop importante dans la paroi, la couche pouvant être fine.

Selon une variante, la couche en matériau résistif est isolée d'un tel volume de matériau de substrat sur une partie de sa surface par un matériau isolant. Selon une autre variante, le volume de matériau de substrat comprend ou est constitué essentiellement d'un matériau isolant, par exemple du verre.

Selon une caractéristique avantageuse, ladite paroi comprend au moins une partie superficielle d'au moins un volume de matériau de substrat qui est en matériau résistif. Cette solution alternative offre l'avantage de la simplicité, puisqu'une seule pièce peut assurer à la fois les fonctions de support et de paroi résistive.

Selon une autre caractéristique avantageuse, les électrodes, par exemple métalliques, qui polarisent ladite paroi en au moins un matériau résistif sont en contact direct avec ladite paroi. Cette caractéristique permet de contrôler précisément les potentiels appliqués sur la paroi résistive.

Selon une caractéristique avantageuse, les au moins deux électrodes en contact direct avec ladite paroi sont elles-mêmes polarisées à distance par l'intermédiaire d'un volume de matériau conducteur faisant partie du substrat. Cette solution permet, tout en ayant un bon contrôle de la polarité, de disposer d'un tube fermé, aisément fabricable.

Selon une caractéristique avantageuse alternative (ou combinée), les au moins deux électrodes en contact direct avec ladite paroi ont des extrémités accessibles à l'extérieur du réflectron, celui-ci étant recouvert d'un capot qui peut être un substrat ayant éventuellement une fonction de support, et les électrodes sont polarisées par ces extrémités accessibles à l'extérieur. Cette solution alternative offre l'avantage d'un excellent contrôle de la polarité appliquée.

Selon différents modes de réalisation, ladite paroi est une couche ou une partie superficielle d'une masse de nitrure de titane, silicium amorphe, polysilicium, germanium, ou oxyde métallique, le matériau pouvant éventuellement être dopé.

L'invention porte également sur un spectromètre de masse à temps de vol incorporant le micro-réflectron. Une partie ou des parties du spectromètre de masse autres que le réflectron (notamment la zone d'injection, mais aussi la chambre d'ionisation, le dispositif d'extraction et de focalisation des ions et/ou le détecteur) peu(vent) également avoir une dimension ou des dimensions micrométriques, et leur fabrication peut être simultanée avec celle du micro-réflectron, dans le cadre d'une fabrication collective.

Plus précisément l'invention porte également sur un spectromètre de masse à temps de vol comportant un micro-réflectron du type précité comportant en outre une source d'ionisation générant des ions et un dispositif d'injection et d'accélération des ions vers le micro-réflectron, ce dispositif d'injection étant obtenu par la technologie des systèmes micro-électromécaniques MEMS sur le même substrat que le micro-réflectron.

Ce choix permet d'assurer la continuité du faisceau d'ions entre la source et l'analyseur : les différents modules du spectromètre sont alignés par construction.

Avantageusement, l'architecture du spectromètre en ce qui concerne la situation du dispositif d'injection et d'accélération est choisie en sorte que l'injection des ions dans l'analyseur se fait orthogonalement à leur trajectoire à la sortie de la source d'ionisation des ions. La sensibilité et la résolution sont ainsi augmentées par rapport à une injection directe.

Selon une caractéristique avantageuse, le dispositif d'injection comporte une paroi résistive qui est polarisée par au moins deux électrodes métalliques séparées de ladite paroi par un volume d'un matériau conducteur. Cette solution est facile à mettre en oeuvre.

Selon un choix de construction, le réflectron est placé dès la sortie du module d'injection, ce qui permet de diminuer les pertes d'ions et donc d'augmenter la sensibilité du dispositif. On précise que le dispositif peut comprendre plusieurs zones de vol libre et plusieurs réflectrons, ainsi que plusieurs dispositifs complémentaires permettant d'augmenter la résolution (filtres en énergie et autres), placés librement selon les besoins.

De manière avantageuse, le spectromètre, comporte en outre un détecteur en sortie du micro-réflectron, et la source d'ionisation et ce détecteur y sont réalisés par la technologie des systèmes micro-électromécaniques sur un même substrat.

De manière également avantageuse, cette source d'ionisation peut, en variante ou en combinaison avec le paragraphe précédent, être réalisée par la technologie des systèmes micro-électromécaniques (MEMS) sur le même substrat que celui du micro-réflectron.

Il va de soi que, lorsque plusieurs éléments sont réalisés par la technologie des MEMS, il est préconisé que de mêmes étapes de cette technologie soient mises en oeuvre conjointement pour les divers éléments.

Une telle fabrication monolithe garantit un excellent positionnement des divers éléments les uns par rapport aux autres, tout en contribuant à la miniaturisation de l'ensemble, puisqu'il n'y a pas à prévoir d'éléments de liaison.

De manière également préférée, la source d'ionisation est fabriquée par usinage volumique de la technologie des systèmes micro-électromécaniques, et comporte une grille d'attraction des électrons et un ensemble d'électrodes constituant une chambre d'ionisation, permettant d'attirer ou repousser des ions formés, cette source d'ionisation étant formée sur le même substrat que le micro-réflectron.

L'invention porte aussi sur un procédé de fabrication d'un micro-spectromètre, en particulier de son micro-réflectron, comprenant une étape de gravure profonde. Il peut s'agir d'une étape de gravure humide ou une étape de gravure sèche, comme par exemple une gravure DRIE, d'un substrat pour former la cavité de la zone de vol des ions ou d'un pochoir servant ensuite à une étape de dépôt épais permettant la formation des parois de la zone de vol des ions.

Dans certains modes de réalisation, le procédé comprend un dépôt d'une couche dudit matériau résistif ou de matériaux constitutifs des électrodes

Selon une caractéristique, le procédé comprend une étape de scellement de deux substrats en sorte de former ladite zone de vol des ions, le scellement étant du type « liaison directe », collage eutectique, liaison anodique ou collage par résine.

Ainsi l'invention propose un procédé de fabrication d'un micro-réflectron du type précité comprenant une étape de gravure humide ou de gravure ionique réactive profonde (DRIE) d'un substrat pour former ladite zone de vol des ions, une étape de dépôt d'une couche dudit au moins un matériau résistif, par exemple par épitaxie, ou d'un matériau constitutif d'électrodes, et une étape de scellement de deux parties du substrat en sorte de former ladite zone de vol des ions, le scellement étant du type « liaison directe », collage eutectique, liaison anodique ou collage par résine.

Le spectromètre de masse à temps de vol proposé peut être utilisé dans des systèmes d'analyse ou de détection chimique de polluants ou de composés toxiques par exemple, portables ou transportables notamment des appareils de terrain autonomes.

Ce spectromètre de masse peut, par exemple, être employé pour contrôler en continu la présence ou non de polluants ou toxiques dans des lieux accueillant du public (réseaux de transports en commun, stades, aéroports ou sites industriels notamment). Cet appareil peut aussi être utilisé comme système d'analyse rapide dans des laboratoires d'analyses biologiques de ville (dans des systèmes d'identification bactérienne par exemple). Il peut aussi être utilisé pour le suivi des chaines de fabrication et distribution agroalimentaires.

L'invention va maintenant être décrite en détails en relation avec les figures annexées.
La figure 1 représente un schéma de principe, connu en soi, d'un spectromètre de masse à temps de vol.
La figure 2 représente un schéma de principe d'un spectromètre de masse à temps de vol muni d'un réflectron conforme à l'invention.
La figure 3 présente une vue générale d'un spectromètre selon l'invention, représenté sans système de détection.
La figure 4 présente une variante d'un premier mode général de réalisation d'un spectromètre selon l'invention.
Les figues 5 à 17 présentent des étapes de fabrication d'une deuxième variante d'un spectromètre selon le premier mode général de réalisation.
Les figures 18 à 21 présentent un deuxième mode général de réalisation d'un spectromètre selon l'invention.
Les figues 22 à 33 présentent des étapes de fabrication d'un spectromètre selon un deuxième mode général de réalisation, la figure 22 constituant un synopsis de l'ensemble du procédé.

En figure 2, on a représenté l'architecture générale d'un spectromètre de masse 1000 selon l'invention.

Un tel spectromètre 1000 est du type à temps de vol. Dans cet appareil, les ions 1010 sont créés en continu dans une chambre d'ionisation 1100 appelée source, et fonctionnant par exemple sur le principe de l'ionisation électronique. Un gaz contenant l'échantillon arrive par un capillaire 1005 dans la chambre d'ionisation. Le gaz est ensuite bombardé par des électrons qui sont générés par un filament.

D'autres modes d'ionisation peuvent être utilisés, notamment l'ionisation par électron-nébuliseur (ESI pour « Electrospray Ionization ») pour des applications biologiques.

Les ions sont extraits de la chambre d'ionisation et leurs trajectoires sont focalisées dans un faisceau de quelques centaines de microns de diamètre par un dispositif d'extraction et de focalisation 1200. Celui-ci utilise un potentiel électrostatique appliqué sur une électrode placée à la sortie de la chambre d'ionisation. Dans l'exemple ici représenté, trois anneaux, polarisés judicieusement, formant un ensemble appelé optique d'Einzel, permettent de focaliser le faisceau d'ions (c'est-à-dire de diminuer son diamètre) avant l'injection de celui-ci dans la zone de vol du spectromètre. Les ions sont aussi accélérés par un dispositif d'injection 1300 où règne un champ électrique 1310.

La vitesse de chaque ion dépend alors de son rapport masse sur charge. La trajectoire des ions passe une ou plusieurs fois par une ou plusieurs zones de vol libre 1400, sans champ (ici, la zone de vol libre est unique, mais est traversée avant et après le passage par le réflectron 1500). Chaque ion a dans cette zone un mouvement uniforme à vitesse constante qui dépend de sa masse. Sur une longueur suffisante tous les ions sont séparés dans le temps en fonction de leurs masses.

De plus, les ions sont déviés par le réflectron 1500 dans lequel règne un champ électrostatique intense de direction opposée à leur trajectoire. Cette région ralentit les ions puis provoque un changement de leur direction.

Le réflectron 1500 comprend une unique paroi continue, ayant ici un fond, polarisée par exemple à ses deux extrémités 1510 (bord libre à gauche sur la figure 2) et 1520 (fond à droite sur la figure 2). Cette paroi est constituée de matériaux résistifs et par conséquent, il n'y a pas de discontinuité de potentiel le long de la paroi, celui-ci variant de manière continue entre les extrémités 1510 d'une part et le fond 1520, d'autre part. Le gradient de potentiel créé le long de la trajectoire des ions est compatible avec les besoins d'un spectromètre de masse MEMS.

Le réflectron 1500 permet de compenser les imperfections liées à la source (dispersions spatiales et énergétiques notamment). Tous les ions de même masse ressortent du réflectron en même temps sur la même ligne.

Un détecteur 1600 compte les arrivées successives de chaque paquet d'ions de même masse. On mesure le temps mis par les ions, depuis leur injection en 1300 (voire depuis leur extraction de la chambre d'ionisation), pour atteindre le détecteur 1600 situé à une distance connue dans le plan focal en sortie du spectromètre. Comme évoqué en introduction, cette durée est appelée temps de vol, et la détermination du rapport masse sur charge découle du temps de vol.

La chambre d'ionisation 1100, le dispositif d'extraction et de focalisation des ions (1200) et le détecteur (1600) peuvent être intégrés, ou non, en technologie MEMS, sur un même substrat ou sur des substrats dont l'un au moins est commun à plusieurs des dispositifs du spectromètre. Le dispositif peut comprendre plusieurs zones de vol libre, et/ou plusieurs réflectrons. Eventuellement des dispositifs de filtrage supplémentaires en énergie ou en masse sont également présents. Il est de plus avantageux que le dispositif d'injection (et d'accélération) 1300 soit fabriqué en technologie MEMS conjointement avec le réflectron, car cela supprime les étapes fastidieuses d'alignement de faisceau entre le dispositif d'injection et le réflectron (l'alignement est assuré par construction).

De manière remarquable, l'injection est orthogonale : le champ électrique d'accélération 1310 est perpendiculaire à la direction d'extraction des ions par le dispositif d'extraction 1200.

Le détecteur 1600 est par exemple un amplificateur à micro-canaux associé à une simple électrode. L'ensemble est connecté à un étage d'adaptation d'impédance puis relié à un échantillonneur numérique (non représentés).

La longueur des différents éléments dépend des caractéristiques que l'on souhaite donner au spectromètre. Les dimensions caractéristiques de ce spectromètre peuvent être proches de (voire inférieures à) 1 cm de côté pour 1.5 mm d'épaisseur (transversalement au plan de la figure 2).

Dans le contexte de l'invention, une dimension proche de 1 cm signifie qu'elle est de l'ordre d'un centimètre, ou de quelques centimètres (typiquement de l'ordre de 2 à 3 centimètres).

Dans un autre mode de réalisation (non représenté), la détection est effectuée par un réseau de nano-poutres (MEMS ou avantageusement NEMS - « Nano Electro Mechanical System »). Ces structures mécaniques mobiles sont des détecteurs gravimétriques mis en oscillations sur leur fréquence de résonance. Tout ajout de masse (d'ion) à leur surface se traduit par un décalage fréquentiel par effet d'inertie. La masse ajoutée est donc évaluée par une électronique de commande qui permet de lire ce décalage fréquentiel.

Suivant d'autres modes de réalisation, la détection des ions en sortie du spectromètre se fait en utilisant différentes techniques comme un channeltron, ou un amplificateur de type galette de micro-canaux.

Le dispositif miniature décrit permet de mettre à profit les performances intrinsèques de l'architecture des spectromètres de masse à temps de vol, à savoir une gamme de masses analysées importante, une bonne sensibilité, notamment en raison de l'injection orthogonale, et l'acquisition du spectre de masse à fréquence élevée.

Le dispositif final étant de petites dimensions (de l'ordre du centimètre au maximum, voir ci-dessus), le libre parcours moyen des ions est considérablement réduit par rapport à celui d'un spectromètre de masse classique. Une des conséquences de l'invention est donc de pouvoir utiliser ce micro-spectromètre à des pressions bien plus élevées (gain d'un facteur 10 au minimum).

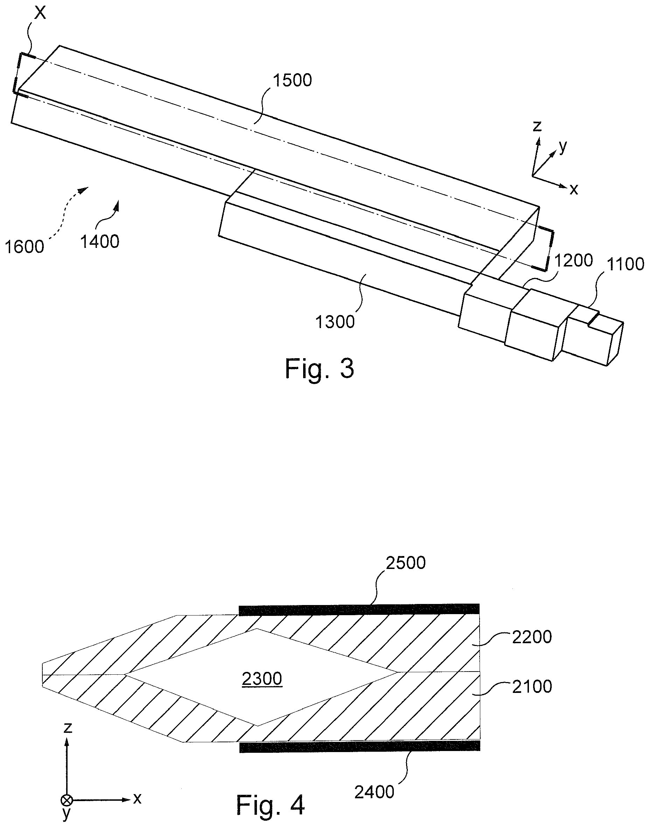

En référence à la figure 3 qui représente en perspective un mode de réalisation du spectromètre selon l'invention (sans élément de détection), la longueur des différents éléments dépend des caractéristiques que l'on souhaite donner au spectromètre. Les dimensions caractéristiques de ce spectromètre, réalisé en technologie MEMS, peuvent être proches de 1 à 3 cm de côté (de gauche à droite, ou de l'avant vers l'arrière sur la figure) pour 1.5 mm d'épaisseur (du haut vers le bas sur la figure). La zone de vol libre 1400 est en aval du réflectron 1500 dans ce mode de réalisation, et est suivie d'un détecteur non représenté (correspondant à la référence 1600 de la figure 2), mais devant être positionné à l'emplacement indiqué par le repère correspondant.

Dans certaines formes de réalisation, le spectromètre de masse est couplé à une colonne de chromatographie (liquide ou gazeuse) et à différentes chambres d'ionisation en fonction du type d'échantillons à analyser (gaz, liquide, échantillon biologique).

Le dispositif est muni d'un système de conditionnement du signal et d'acquisition numérique rapide (non représenté, de tout type connu approprié). Une marge de progression importante est encore possible sur les systèmes d'acquisition actuels, ce qui permettra dans le futur de diminuer d'autant les dimensions du spectromètre de masse.

La gamme des masses détectée est très importante, un facteur limitant étant la résolution temporelle de l'échantillonneur numérique utilisé pour la mesure (au détecteur). Les mesures peuvent ainsi s'étendre facilement aux ions de 1 à 10.000 uma (unité de masse atomique). La résolution est importante et est, par exemple, très supérieure à 1000 pour des ions de 1000 uma.

En référence à la figure 4, qui représente une coupe proche de celle des parties 1200 et 1100 (dans un plan à « x » constant), par exemple au travers du dispositif d'injection 1300 précédant le réflectron 1500 perpendiculairement au plan référencé X en figure 3, le spectromètre de masse est réalisé, comme évoqué précédemment, en technologie MEMS. Un premier procédé de fabrication repose sur la gravure chimique anisotrope profonde à la potasse (KOH) de deux wafers (aussi appelés substrats ou plaquettes) de silicium 2100 et 2200.

Cette gravure permet de former la cavité 2300 dans laquelle les champs électriques nécessaires au fonctionnement du spectromètre sont, après assemblage et polarisation, appliqués. Cette cavité 2300 est aussi appelée tube. La trajectoire des ions est confinée dans le tube. Les deux wafers 2100 et 2200 sont assemblés par soudure. La dimension représentée du haut vers le bas est l'épaisseur.

Une succession (transversalement au plan de la figure 4) de fines pistes métalliques 2400 et 2500 parallèles les unes aux autres est déposée sur chacune des faces extérieures afin d'appliquer les potentiels électriques souhaités le long de la trajectoire des ions pour leur accélération. Les wafers 2100 et 2200 considérés dans ce mode de réalisation sont en silicium avec un dopage suffisant pour assurer une bonne mise en polarisation de la cavité 2300. La surface du silicium dans la cavité 2300 est nue, et c'est la partie superficielle du silicium des wafers 2100 et 2200 qui constitue une paroi en matériau résistif qui crée le champ électrique dans la cavité 2300. La partie superficielle du wafer 2100 est intégrée au volume du support que constitue le wafer 2100. De la même manière la partie superficielle du wafer 2200 est intégrée au volume du support que constitue le wafer 2200. Les électrodes 2400 et 2500 sont mises au même potentiel dans le plan de la figure 4. Comme indiqué ci-dessus, dans un plan parallèle à celui de la figure 4, mais décalé par rapport à celui-ci, deux autres électrodes 2400 et 2500 sont mises à un deuxième potentiel, ce qui crée un gradient de potentiel dans la paroi en matériau résistif, perpendiculairement au plan de la figure 4.

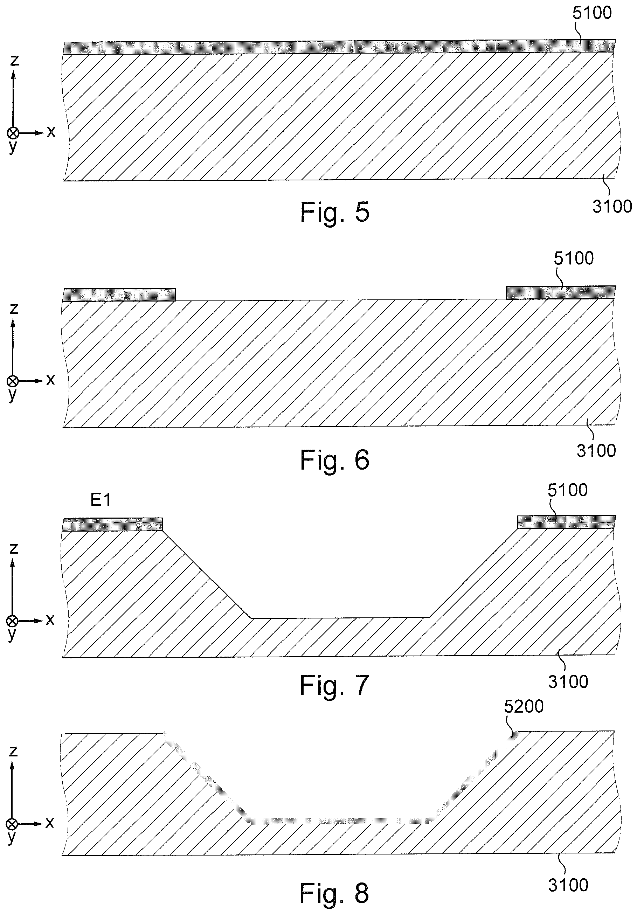

Dans le cadre d'une variante du mode de réalisation de la figure 4, un exemple de procédé est décrit à propos du réflectron aux figures 5 à 17, qui, comme la figure 4, sont des vues en coupe du tube dans lequel circulent les ions ; plus précisément il s'agit de vues en coupe de la zone qui est destinée à servir de réflectron, suivant ou parallèle plan qui est représenté sous la référence X en figure 3.

La figure 5 représente une couche diélectrique 5100 d'oxyde de silicium et/ou de nitrure de silicium, déposée de manière continue sur le wafer 3100. Dans un mode de réalisation non représenté, on utilise un bi-couche oxyde/nitrure de silicium.

La figure 6 représente cette couche 5100 après qu'elle a été structurée par lithographie et gravure. La gravure peut être une gravure RIE (gravure ionique réactive - « Reactive Ion Etching ») par exemple. Certaines zones de la couche 5100 ont été entièrement supprimées, ce qui permet d'utiliser la couche 5100 pour former un masque, définissant un motif horizontal de gravure. On procède alors à une étape E1 de gravure, ici dans un bain de potasse (KOH).

La figure 7 représente le résultat de la gravure KOH du silicium. Les zones conservées de la couche 5100 ont protégé les zones de silicium lors de la gravure (le matériau constitutif de cette couche a été choisi en conséquence).

Une moitié du futur tube du spectromètre (ici au niveau du réflectron) prend ainsi une forme de V comprenant un fond plat. La pente et la profondeur de la gravure sont fixées par l'orientation cristalline du silicium et par la durée de la gravure. En fonction de l'intensité de la gravure (qui est toujours néanmoins du type gravure profonde), le fond plat peut être réduit à une très faible longueur, voire ne pas être présent, comme cela a été représenté en figure 4 à propos de la zone d'injection.

En fonction du motif horizontal de gravure défini à l'étape précédente, on a formé l'ensemble des éléments du spectromètre fabriqués dans la technologie MEMS, notamment la zone du réflectron 1500, la zone d'injection 1300, et éventuellement les zones d'ionisation et de focalisation 1100 et 1200, les zones de gravure dans un substrat avantageusement commun à ces divers éléments ayant pu changer de direction, transversalement à l'épaisseur, d'une zone à l'autre. On retire à ce stade le masque d'oxyde ou de nitrure 5100.

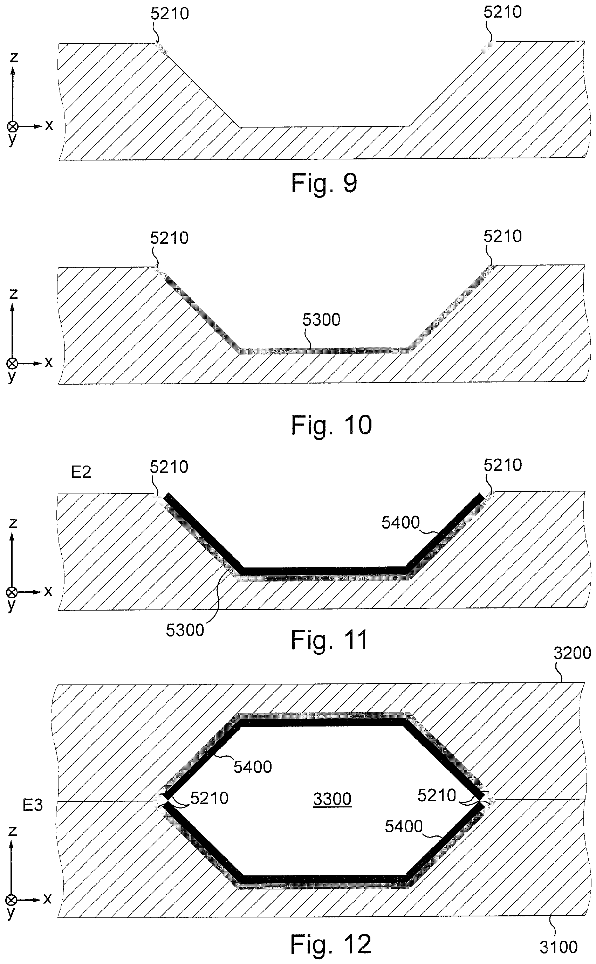

Les figures 8 et 9 représentent le dépôt d'électrodes 5200 et 5210 dans le canal gravé, au niveau du réflectron. Ce dépôt n'est pas effectué dans tout le tube du spectromètre, et n'est mis en oeuvre que dans le cadre d'un exemple de réalisation. Il n'est notamment pas mis en oeuvre dans le cadre du mode de réalisation de la figure 4 à propos de la zone d'injection. Le dépôt peut être effectué à travers un pochoir par exemple. Dans un mode de réalisation, on utilise un procédé de lift-off notamment sur pente douce. Les électrodes 5200 et 5210 peuvent être constituées d'une couche d'or, d'or au Cr/Au ou plus généralement d'une ou plusieurs couches d'un matériau conducteur.

La figure 8 montre la forme d'une électrode 5200. L'ensemble de la surface du V, incluant les deux surfaces inclinées des bords et la surface plane du fond, est recouvert par le métal de l'électrode. Cela peut être en particulier le cas à l'extrémité du réflectron.

La figure 9 montre quant à elle la forme, dans un mode de réalisation, d'une électrode 5210 dans la zone qui va plus tard être utilisée comme réflectron. Le silicium 3100 est dans cette dernière zone laissé à nu sur la majeure partie du V.

On dépose ensuite une couche d'isolant 5300 sur la surface du silicium laissée à nu. Ce dépôt est effectué par exemple par PECVD (« plasma enhanced chemical vapor déposition ») puis structuré par lithographie. La figure 10 montre la couche isolante 5300 déposée ainsi sur les parois de silicium du V dans la zone destinée à servir de réflectron (le plan de coupe est le même que celui de la figure 9), entre les électrodes 5210.

On dépose ensuite une couche résistive 5400 dans la zone qui va plus tard être utilisée comme réflectron, sur la couche d'isolant 5300 et sur les électrodes 5210. Le dépôt (étape E2) peut être fait par épitaxie. Différents procédés de dépôt peuvent être utilisés pour l'étape E2 : CVD (« chemical vapor déposition »), PECVD, PVD (« physical vapor déposition »), pulvérisation, évaporation sous vide, dépôt électrolytique, notamment. On utilise également un pochoir ou des étapes de lithographie/gravure. Cette couche 5400 peut être notamment constituée de silicium amorphe, de nitrure de titane ou d'oxyde métallique et peut avoir une épaisseur comprise entre 10 nm et quelques 100 nm.

La figure 11 montre la forme finale de la couche résistive 5400 déposée dans la zone du réflectron. Cette couche 5400 forme une paroi intégrée au volume composé de l'empilement 3100-5300-5400-5210.

On précise à ce stade que l'étape de dépôt de l'électrode 5210, représentée à propos de la zone de réflectron, est optionnelle dans d'autres zones du tube, même quand on procède au dépôt d'une couche résistive 5400, puisqu'elle dépend du choix que l'on fait ou non d'isoler sur sa plus grande surface la couche résistive 5400 du silicium, dont on rappelle qu'il est conducteur.

De manière avantageuse, la couche 5300 permet d'isoler le film résistif 5400 du silicium conducteur 3100 sur la plus grande surface du film 5400, mais ses extrémités sont en contact avec l'électrode 5210 si elle est présente, ou le substrat 3100. Ainsi, il n'y a pas de court-circuit du film résistif 5400.

On procède ensuite à l'assemblage face à face de deux structures similaires à celle qui vient d'être préparée à la figure 11 (étape E3). La figure 12 donne un exemple de scellement par liaison ou collage direct (« direct bonding ») silicium sur silicium de ces deux structures, où les wafers de silicium sont référencés 3100 et 3200. Un scellement eutectique (or/étain Au/Sn par exemple) est aussi utilisé dans un mode de réalisation alternatif. Ce scellement permet de réaliser le tube 3300 du spectromètre, ici représenté dans sa zone de réflectron. La dimension représentée du haut vers le bas est l'épaisseur.

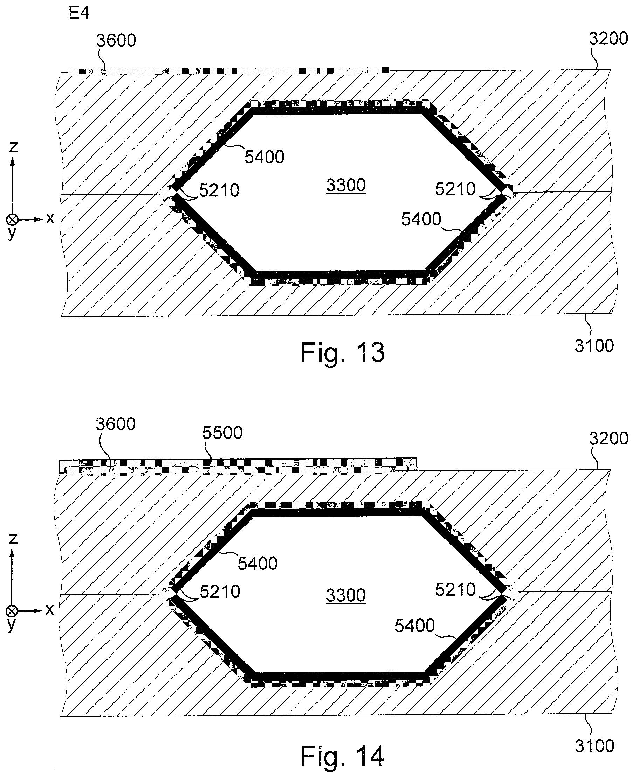

La figure 13 représente le dépôt d'une électrode 3600 permettant de polariser la zone d'intérêt (une électrode similaire a déjà été évoquée en relation avec la figure 4). Cette électrode 3600 est une couche métallique (or ou alliage aluminium-silicium par exemple). Dans un mode de réalisation, elle est déposée par PVD (dépôt physique par phase vapeur) puis gravée à travers un masque de résine. Cette étape est notée étape E4.

Deux autres étapes de gravure sont ensuite pratiquées sur l'empilement pour extraire le dispositif de l'ensemble constitué par la partie extérieure des wafers de silicium.

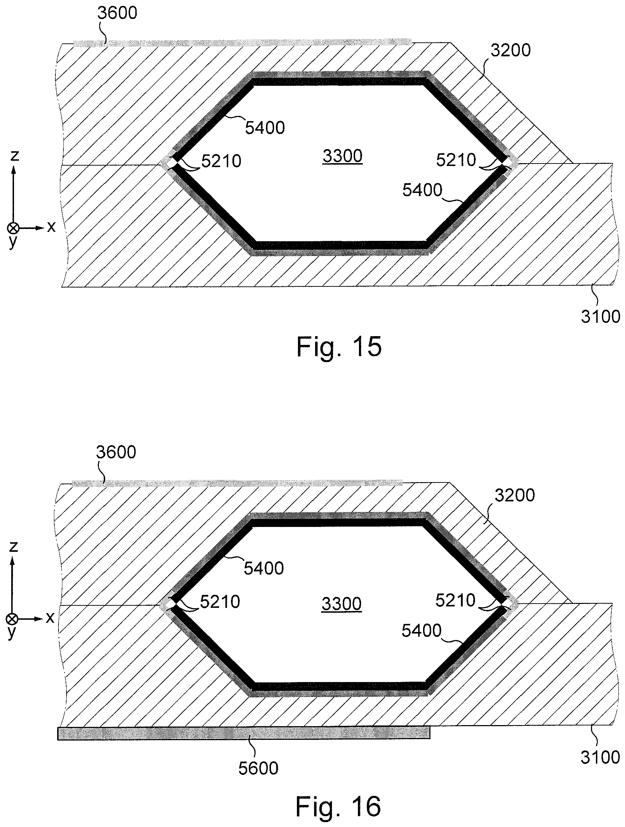

La figure 14 représente le dépôt d'un masque physique 5500 (un oxyde ou un nitrure par exemple) sur la surface du wafer de silicium 3200, pour protéger les zones ne devant pas être gravées, parmi lesquelles l'électrode 3600. Une gravure est alors pratiquée sur l'extérieur du wafer 3200. La gravure est ici une gravure KOH. Il est aussi possible de pratiquer une gravure DRIE. La figure 15 donne le résultat de cette étape, après que le masque 5500 ait été retiré.

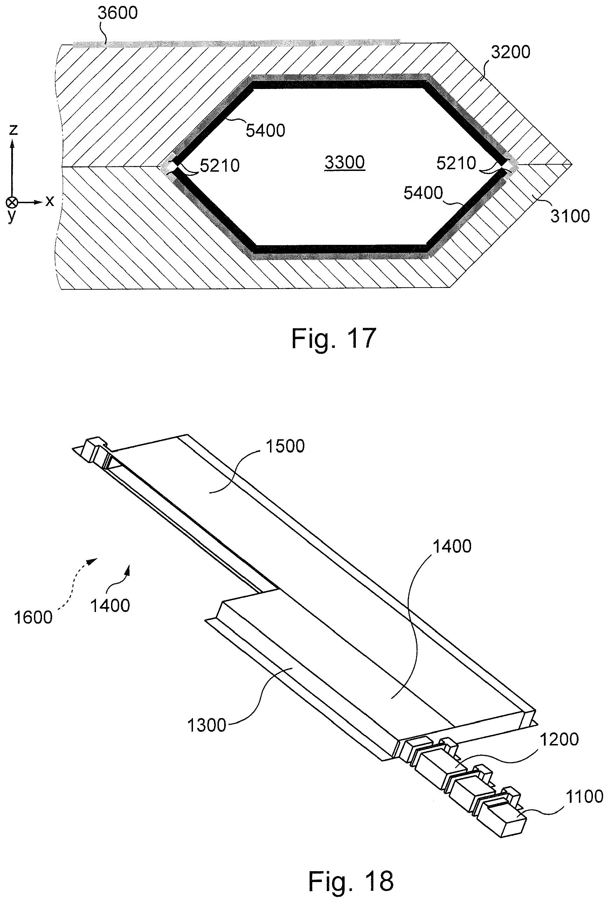

La figure 16 représente un masque physique 5600 sur la surface extérieure du wafer de silicium 3100, protégeant les zones du wafer 3100 ne devant pas être gravées. La figure 17 représente le tube final lorsqu'une seconde gravure KOH a été pratiquée sur la face arrière (inférieure) de l'empilement. Là aussi, la gravure peut être une gravure DRIE à titre de variante.

De plus, une électrode similaire à l'électrode 3600 peut être déposée sur la surface du wafer 3100 afin d'obtenir, après assemblage et polarisation, des couches présentes des deux côtés de la structure, assurant ainsi une meilleure homogénéité des champs électriques dans le tube 3300 (comme dans le mode de réalisation représenté en figure 4).

On comprend que, puisque les couches 5400 sont en matériau résistif, l'application d'une différence de potentiel entre les électrodes métalliques 5210 provoque une variation continue de potentiel au sein de ces couches 5400 en allant de l'une à l'autre de ces électrodes (par exemple une augmentation depuis la gauche vers la droite, comme entre les zones 1510 et 1520 de la figure 2), d'où l'effet de réflectron voulu.

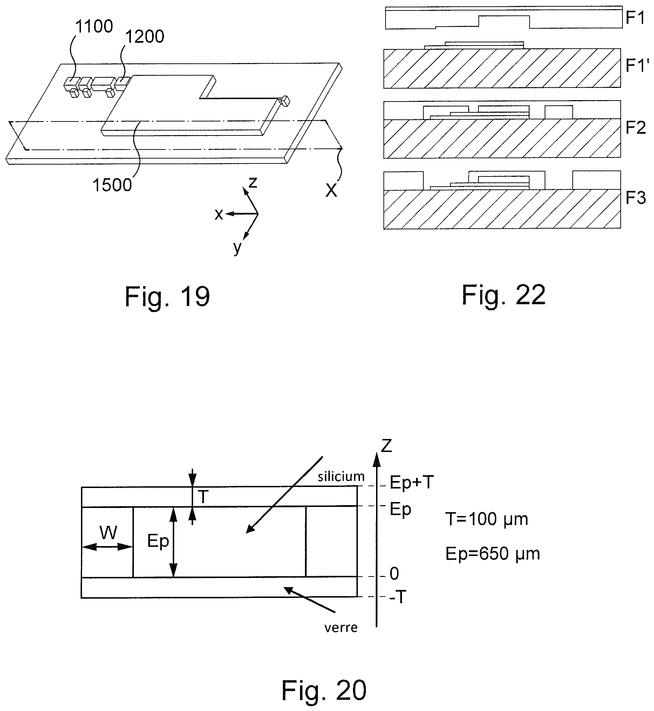

Selon un deuxième mode général de réalisation, la technique de gravure RIE profonde (DRIE pour « Deep-reactive ion etching » en anglais) est employée pour la fabrication du dispositif. Il s'agit là encore d'une gravure anisotrope. La figure 18 présente le dispositif résultant du procédé selon cette deuxième voie de fabrication. Sur cette figure, on a utilisé les mêmes références numériques qu'en figure 3. Comme en figure 3, la zone de vol libre 1400 est placée en aval du réflectron 1500, et le détecteur 1600 n'est pas représenté, mais doit être positionné à l'emplacement indiqué par le repère correspondant. La figure 19 présente une autre vue du dispositif final, sur laquelle on a indiqué un plan de coupe x-x transversalement auquel les différentes étapes du procédé de fabrication vont être décrites ci-après en ce qui concerne le réflectron.

La figure 22 présente les grandes étapes du processus de fabrication. Une première phase F1 comprend une étape de gravure d'un substrat de silicium qui permet de réaliser le canal dans lequel les ions vont transiter. Une phase parallèle F1' comprend une étape de dépôt sur un substrat de verre d'un film résistif qui va constituer une partie du réflectron.

Les deux substrats sont ensuite soudés l'un à l'autre au cours d'une phase F2, ce qui permet de constituer le tube du spectromètre, et plus particulièrement le tube du réflectron.

Une phase de gravure F3 est ensuite effectuée pour définir les contours du spectromètre de masse et former l'étage de focalisation 1200 (non représenté). A l'issue de cette étape, le micro-spectromètre est disponible, isolé sur son support de verre.

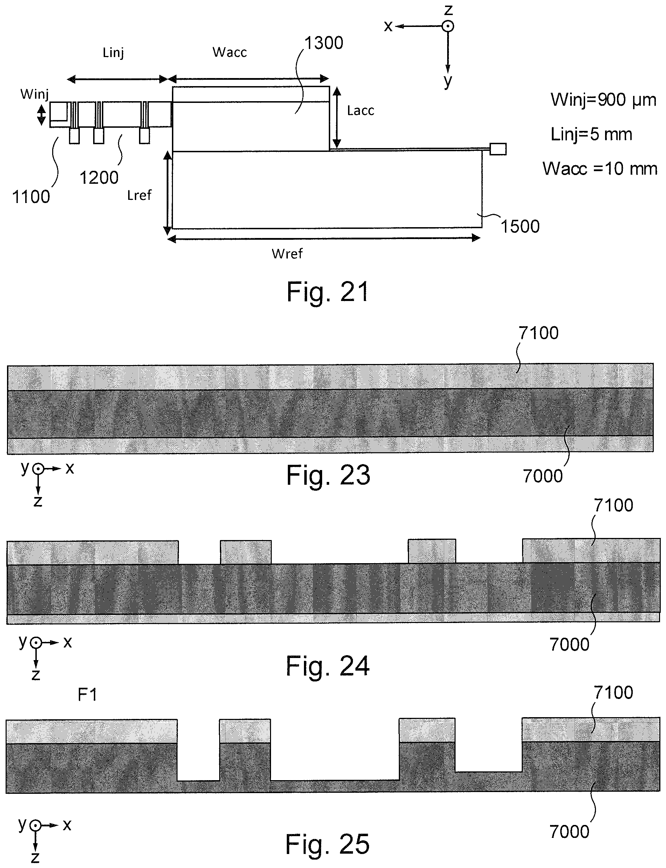

A titre non limitatif, les dimensions du dispositif final dans son épaisseur (en z) et des dimensions typiques dans le plan (x, y) sont indiquées aux figures 20 et 21 (épaisseurs de verre de quelques centaines de micromètres, par exemple 100 micromètres, séparées d'un tube de 650 micromètres d'épaisseur ; une longueur d'injection de 5 mm sur une épaisseur de 900 micromètres, une longueur de la zone d'accélération de 10 mm, d'où, compte tenu des proportions, une longueur de réflectron de l'ordre de 20 mm pour une largeur globale de l'ordre de 15-20 mm); les dimensions du spectromètre en largeur et en longueur sont typiquement inférieures à 3 cm au total, pour une épaisseur inférieure à 5, voire 3 mm ou même 2 mm. A titre d'ordre de grandeur les dimensions d'un exemple de micro spectromètre selon l'invention valent environ le diamètre d'une pièce de deux euros (2.5 cm), à 20% près.

En référence à la figure 23, on choisit tout d'abord un wafer 7000 en silicium poli sur les deux faces sur lequel une couche d'oxyde de silicium (SiO₂) 7100 est déposée (par exemple par procédé PECVD - « Plasma-enhanced chemical vapor déposition » en anglais pour dépôt chimique en phase vapeur assisté par plasma - ou alternativement par oxydation thermique) sur une épaisseur de 5 à 10 µm par exemple comme représenté à la figure 23. Cette couche d'oxyde 7100 est utilisée par la suite comme masque physique protégeant les zones qui ne doivent pas être gravées.

Le résultat d'une gravure sèche (par exemple RIE) de la couche d'oxyde 7100 est représentée à la figure 24. Elle permet de supprimer l'oxyde sur les zones du wafer 7000 qui doivent être gravées pendant l'étape de DRIE.

La figure 25 représente l'étape de gravure profonde F1 qui sert à évider le silicium du wafer 7000 pour permettre le passage des ions du futur spectromètre. La gravure est profonde sur une épaisseur de plusieurs centaines de microns.

La couche d'oxyde 7100 est ensuite retirée, par acide fluorhydrique (HF) par exemple (non représenté).

La partie superficielle du volume de silicium 7000 constitue une paroi en matériau résistif intégrée dans le volume du substrat constitué par le silicium 7000. Si on conserve à celui-ci une épaisseur suffisante pendant tout le procédé de fabrication, ce volume a une fonction de support mécanique. Néanmoins, comme présenté aux figures suivantes, la fonction de support mécanique peut être confiée à un support de verre.

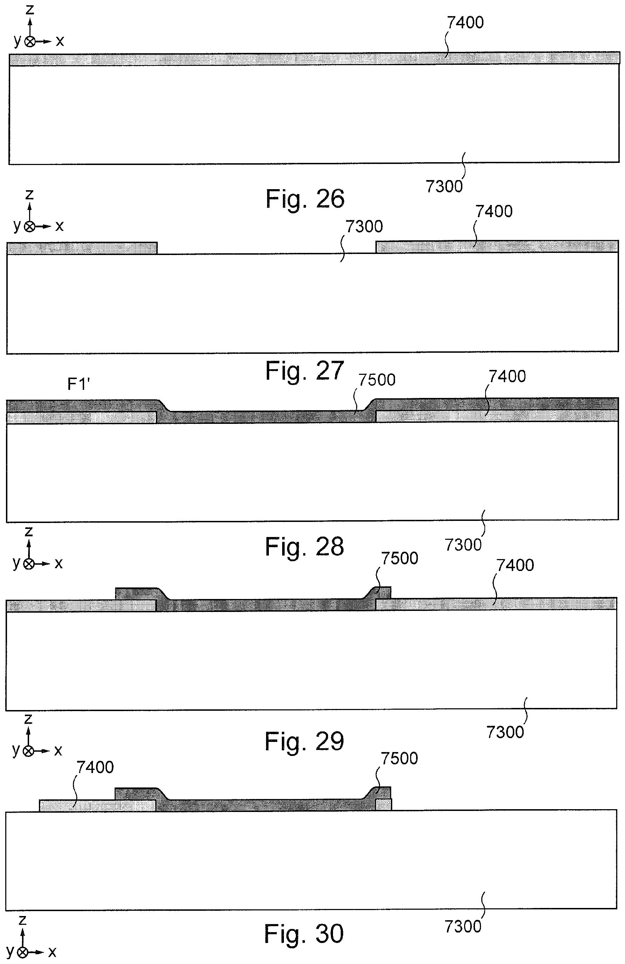

En référence à la figure 26, on utilise ensuite une plaque de verre 7300 polie sur les deux faces sur laquelle une électrode 7400 est déposée. Celle-ci est constituée d'une couche de métal (par exemple alliage aluminium-silicium AISi, tungstène W, aluminium Al ou titane Ti) d'épaisseur de quelques centaines de nanomètres, par exemple 500 nm, qui est déposée par pulvérisation (PVD pour « Physical vapor déposition » ou dépôt physique par phase vapeur). Une technique d'évaporation peut aussi être utilisée.

La plaque de verre 7300 a un rôle de capot protecteur dans le dispositif final et supporte également les électrodes de polarisation 7400.

Des étapes de gravure du métal 7400 sont ensuite réalisées et le résultat est montré à la figure 27. La gravure est faite avantageusement par voie humide (avec un bain de gravure adapté au métal choisi) mais peut être réalisée par plasma. Cette étape permet d'enlever le métal dans la zone du réflectron entre deux électrodes successives afin que la surface du film résistif déposé par la suite soit isolée du métal.

Un film résistif 7500 fin est ensuite déposé comme représenté à la figure 28 (étape F1'). Il peut être constitué d'un matériau semi-conducteur, comme par exemple du silicium amorphe, du poly-silicium ou du germanium ou d'un autre matériau. La technique de dépôt peut être l'épitaxie. L'épaisseur dépend de la résistivité du matériau choisi et peut être comprise entre quelques nanomètres et quelques centaines de nanomètres, soit par exemple entre 5 et 500 nm. La résistivité du film 7500 peut aussi être modulée en dopant le cas échéant le matériau utilisé.

Des étapes de gravure du film résistif 7500 sont ensuite réalisées. Le film résistif 7500 est enlevé partout en-dehors du tube. Le résultat est montré à la figure 29. La gravure est de préférence sèche par plasma mais pourrait être réalisée par une méthode humide.

Une dernière série d'étapes de gravure de l'ensemble électrode 7400 et film résistif 7500 est réalisée pour définir la forme des électrodes. Le résultat est montré à la figure 30. De manière importante, l'électrode 7400 dépasse latéralement du film résistif 7500.

Aux figures 28, 29 et 30, le film résistif 7500 constitue une paroi intégrée au volume constitué de l'empilement 7300-7400-7500.

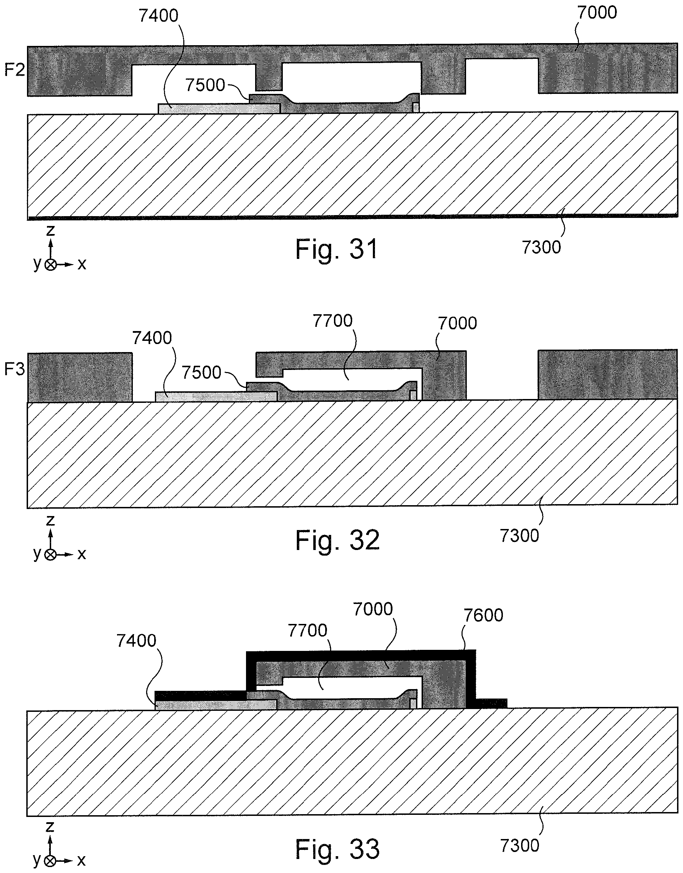

Finalement, la plaque de verre 7300 et le wafer de silicium 7000 sont scellés entre eux (étape F2). La technique choisie est celle de la soudure anodique (« anodic bonding ») qui induit des liaisons chimiques à l'interface entre le verre de la plaque 7300 et le silicium du wafer 7000 en comprimant, chauffant et en polarisant l'empilement silicium/verre. La température peut être de 500°C pour un potentiel de l'ordre de 1 kV. Le collage peut aussi être réalisé par d'autres techniques comme le collage par résine, ou des collages eutectiques (étain-plomb SnPb, or-étain AuSn...). Cette étape est représentée à la figure 31.

Le wafer de silicium 7000 est ensuite gravé lors d'une seconde étape DRIE (étape F3) à travers un masque en résine ou oxyde (non représenté). Cette étape dont le résultat est représenté en figure 32 permet de finaliser le tube 7700 dans lequel vont se déplacer les ions (perpendiculairement au plan de la figure) et d'isoler les parties du spectromètre qui doivent être isolées. A titre d'exemple, l'optique de focalisation (repère 1200 en figure 18) est constituée d'anneaux en silicium posés sur verre séparés d'un espace de l'ordre de 1 mm par exemple. De manière importante, l'électrode reste accessible depuis l'extérieur du tube, alors que le film résistif 7500 est essentiellement enterré.

Un dernier dépôt métallique est ensuite réalisé pour former des électrodes enrobantes 7600 autour du tube du spectromètre. Dans l'exemple, une technique dite de « lift-off » est utilisée pour structurer le dépôt. Le résultat de cette dernière étape est présentée en figure 33.

On obtient à ce stade un ensemble intégré porté par un support constitué de la plaque de verre 7300. Une telle fabrication collective permet de fabriquer un lot comportant un grand nombre de spectromètres se présentant sous la forme de puces. Les puces « spectromètre » sont alors découpées.

Les électrodes 7400 et 7600 sont polarisées au même potentiel dans le plan de la figure 33. Deux autres électrodes 7400 et 7600, dans un deuxième plan, parallèle à celui de la figure 33 mais décalé par rapport à celui-ci, sont polarisées à un deuxième potentiel. Les potentiels sont transmis au film résistif 7500 et à la masse de silicium 7000, respectivement. Le film résistif 7500, qui est fin, et la partie superficielle (à l'intérieur du dispositif) de la masse de silicium 7000, créent un champ électrique dans la cavité 7700, un gradient de potentiel se développant entre le plan de la figure 33 et le plan parallèle décalé par rapport à celui-ci. Cela permet d'obtenir une accélération dans le tube représenté. Dans la zone formant réflectron, la différence de potentiel peut être établie entre les électrodes droite et gauche, un gradient continu de potentiel étant obtenu entre ces électrodes droite et gauche.

A titre de variante, la plaque de verre 7300 peut être remplacée par une plaque en silicium. On privilégie dans ce cas un substrat silicium haute résistivité de sorte que les électrodes 7400 ne soient pas court-circuitées. De même, le collage entre les plaques 7000 et 7300 peut se faire par une technique de « direct bonding » silicium/silicium assurant un scellement à haute résistance. La dernière étape de gravure DRIE du silicium, entre les figures 31 et 32, peut aussi être remplacée par une gravure à la potasse (KOH).

De manière générale, les procédés de fabrication sont ainsi basés sur les technologies de gravure en volume (DRIE, KOH, voire gravure au tetramethylammonium hydroxide TMAH). La gravure profonde d'un substrat permet la définition de la cavité dans laquelle les ions se déplacent et subissent le champ électrostatique du réflectron.

Alternativement, la gravure profonde peut être utilisée pour structurer en volume un pochoir, qui est ensuite utilisé pour une ou des étapes de dépôt épais qui permettent de définir les parois du réflectron. Une fois le pochoir écarté, la cavité du réflectron apparaît entre ces parois.

Dans les différents modes de réalisation, les étapes de collage de plaques peuvent être remplacées par un procédé de fabrication par report puce à puce.

Dans tous les modes de réalisation présentés, la paroi en matériau résistif formant réflectron est affleurante à la surface d'un substrat ou d'un empilement fondé sur un substrat servant de support pendant certaines étapes de fabrication, voire une fois que le dispositif est assemblé. La paroi affleure dans la cavité servant de zone de vol des ions, dans laquelle elle crée un champ électrostatique.

Dans des variantes non représentées, la paroi en matériau résistif peut aussi être enterrée dans le substrat ou dans un empilement fondé sur le substrat, par exemple sous une couche ou un volume de matériau de permittivité proche de celle du vide ou de celle de l'air, ou d'épaisseur faible. Elle crée alors un champ électrostatique à la fois dans la couche ou le volume de matériau de permittivité proche de celle du vide ou de celle de l'air et dans la cavité servant de zone de vol des ions.

Dans toutes ces variantes, la paroi est intégrée au volume d'un substrat.

En résumé, les voies de fabrication présentées permettent la miniaturisation du spectromètre à temps de vol et de son réflectron. Ainsi, l'architecture temps de vol associée au procédé de fabrication décrit permet d'intégrer les différents éléments du spectromètre sur une unique puce, et de proposer un appareil miniature, fabricable en série et ayant une résolution importante pour des gammes de masse étendues.

L'invention ne se limite pas aux modes de réalisation présentés et englobe toutes les variantes dans les limites des revendications indépendantes.

## Revendications

1. Micro-réflectron pour spectromètre de masse à temps de vol comprenant un substrat (2100 ; 3100, 5300, 5400 ; 7300, 7400, 7500 ; 7000) et, intégrés au volume du substrat, des moyens (2100 ; 5400 ; 7500 ; 7000) d'application d'un gradient de potentiel dans un volume adapté à constituer une zone de vol des ions (2300 ; 3300 ; 7700), **caractérisé en ce que** le substrat est formé de l'assemblage de deux wafers dans l'un au moins desquels un canal est formé par gravure en sorte de conformer la zone de vol en un tube, lesdits moyens d'application comprennent au moins deux électrodes de polarisation (5210, 7400) s'étendant le long du tube et le tube a une paroi en au moins un matériau résistif adaptée à être polarisée entre ces électrodes en sorte de générer un gradient continu de potentiel en assurant elle-même la fonction de réflectron, cette zone de vol, ces électrodes et cette paroi étant obtenues par la technologie de gravure/dépôt/assemblage des systèmes micro-électromécaniques MEMS et ce micro-réflectron ayant une épaisseur inférieure à 5 millimètres, tandis que ses autres dimensions sont inférieures à 10 fois cette épaisseur.

2. Micro-réflectron selon la revendication 1, dans lequel ladite paroi comprend au moins une couche en matériau résistif (5400 ; 7500) déposée sur une surface d'un desdits wafers, lequel constitue un volume du substrat (3100, 3200, 5300 ; 7300).

3. Micro-réflectron selon la revendication 2, dans lequel la couche en matériau résistif (5400) est isolée de ce volume du substrat (3100, 3200) sur une partie de sa surface par un matériau isolant (5300).

4. Micro-réflectron selon la revendication 2 ou la revendication 3, dans lequel ledit volume du substrat comprend un matériau isolant (7300).

5. Micro-réflectron selon la revendication 1, dans lequel ladite paroi comprend au moins une partie superficielle d'au moins l'un desdits wafers, lequel constitue un volume du substrat (2100, 2200 ; 7000), celui-ci étant en au moins un matériau résistif.

6. Micro-réflectron selon l'une quelconque des revendications 1 à 5, dans lequel les électrodes (5210 ; 7400) qui polarisent la paroi (5400 ; 7500) en au moins un matériau résistif sont en contact direct avec ladite paroi.

7. Micro-réflectron selon la revendication 6, dans lequel les au moins deux électrodes (5210) en contact direct avec ladite paroi (5400) sont, elles-mêmes, polarisées (3600) au moins à distance, par une électrode extérieure, par l'intermédiaire d'un volume de matériau conducteur (3100, 3200) faisant partie du substrat.

8. Micro-réflectron selon la revendication 6 ou la revendication 7, dans lequel les au moins deux électrodes (7400) en contact direct avec ladite paroi (7500) ont des extrémités accessibles à l'extérieur du réflectron, celui-ci étant recouvert d'un capot (2100, 2200 ; 3100, 3200 ; 7000, 7300), les au moins deux électrodes étant polarisées au moins par ces extrémités accessibles à l'extérieur.

9. Micro-réflectron selon l'une des revendications précédentes, dans lequel ladite paroi (2100, 2200 ; 5400 ; 7000, 7500) est en nitrure de titane, en silicium amorphe, en polysilicium en germanium ou en oxyde métallique.

10. Spectromètre de masse comprenant un micro-reflectron selon l'une quelconque des revendications de micro-reflectron 1 à 9, comportant en outre une source d'ionisation (1100, 1200) générant des ions et un dispositif d'injection et d'accélération des ions vers le micro-réflectron, ce dispositif d'injection étant obtenu par la technologie des systèmes micro-électromécaniques MEMS sur le même substrat que le micro-réflectron.

11. Spectromètre de masse selon la revendication 10, dans lequel le dispositif d'injection et d'accélération est disposé de telle manière que l'injection des ions (1300) se fait orthogonalement par rapport à leur trajectoire à la sortie de la source d'ionisation des ions (1200).

12. Spectromètre de masse selon la revendication 10 ou la revendication 11, dans lequel le dispositif d'injection comporte une paroi résistive polarisée par au moins deux électrodes (2400, 2500) séparées de ladite paroi par un volume d'un matériau conducteur (2100, 2200).

13. Spectromètre de masse selon l'une quelconque des revendications 10 à 12, comportant en outre un détecteur (1600) en sortie du micro-réflectron, et dans lequel la source d'ionisation (1100) et ce détecteur sont réalisés par la technologie des systèmes micro-électromécaniques sur un même substrat.

14. Spectromètre de masse selon l'une quelconque des revendications 10 à 13, dans lequel la source d'ionisation est fabriquée par usinage volumique de la technologie des systèmes micro-électromécaniques, et comporte une grille d'attraction des électrons et un ensemble d'électrodes constituant une chambre d'ionisation, permettant d'attirer ou repousser des ions formés, cette source d'ionisation étant formée sur le même substrat que le micro-réflectron.

15. Procédé de fabrication d'un micro-réflectron selon l'une quelconque des revendications 1 à 9, comprenant une étape de gravure humide (E1) ou de gravure ionique réactive profonde (DRIE) (F1) d'un wafer d'un substrat (2100, 2200 ; 3100, 3200 ; 7000) pour former un canal en sorte de former au moins une partie d'une zone de vol des ions (2300 ; 3300 ; 7700), une étape de dépôt (E2 ; F1') d'une couche (5400 ; 7500) d'au moins un matériau résistif, par exemple par épitaxie, et d'un matériau constitutif d'électrodes de polarisation, et une étape de scellement (E3, F2) de ce wafer à un autre wafer du substrat en sorte de former un tube définissant ladite zone de vol des ions (2300 ; 3300 ; 7700) dont la paroi est en au moins un matériau résistif et le long duquel s'étendent les électrodes de polarisation, le scellement étant du type « liaison directe », collage eutectique, liaison anodique ou collage par résine.

## Patentansprüche

1. Mikro-Reflektron für Flugzeit-Massenspektrometer, enthaltend ein Substrat (2100; 3100, 5300, 5400; 7300, 7400, 7500; 7000) und dem Volumen des Substrats integriert Mittel (2100; 5400; 7500; 7000) zum Anlegen eines Spannungsgradienten in einem Volumen, das dazu ausgelegt ist, einen lonenflugbereich (2300; 3300; 7700) zu bilden, **dadurch gekennzeichnet, dass** das Substrat aus der Zusammenfügung von zwei Wafern besteht, bei welchen zumindest in einem ein Kanal durch Ätzen gebildet ist, so dass der Flugbereich röhrenförmig ausgebildet ist, wobei die Anlagemittel zumindest zwei Vorspannungselektroden (5210, 7400) aufweisen, die sich entlang der Röhre erstrecken und die Röhre eine Wand aus zumindest einem resistiven Material enthält, die dazu ausgelegt ist, zwischen diesen Elektroden so vorgespannt zu werden, dass sie einen kontinuierlichen Spannungsgradienten erzeugt, indem sie selbst die Funktion des Reflektrons übernimmt, wobei dieser Flugbereich, diese Elektroden und diese Wand durch die Technik Ätzen/Abscheiden/Zusammenfügen von mikro-elektromechanischen Systemen MEMS erhalten werden und wobei dieses Mikro-Reflektron eine Dicke von unter 5 Millimeter hat, während seine weiteren Abmessungen unter dem 10-fachen dieser Dicke liegen.

2. Mikro-Reflektron nach Anspruch 1, wobei die Wand zumindest eine Schicht aus resistivem Material (5400; 7500) enthält, die auf einer Fläche eines der Wafer abgeschieden ist, der ein Volumen des Substrats (3100, 3200; 5300; 7300) darstellt.

3. Mikro-Reflektron nach Anspruch 2, wobei die Schicht aus resistivem Material (5400) von diesem Volumen des Substrats (3100, 3200) über einen Teil ihrer Fläche durch ein Isoliermaterial (5300) isoliert ist.

4. Mikro-Reflektron nach Anspruch 2 oder Anspruch 3, wobei das Volumen des Substrats ein Isoliermaterial (7300) enthält.

5. Mikro-Reflektron nach Anspruch 1, wobei die Wand zumindest einen Oberflächenabschnitt von zumindest einem der Wafer enthält, der ein Volumen des Substrats (2100, 2200; 7000) darstellt, wobei dieses aus zumindest einem resistiven Material besteht.

6. Mikro-Reflektron nach einem der Ansprüche 1 bis 5, wobei die Elektroden (5210; 7400), welche die Wand (5400; 7500) aus zumindest einem resistiven Material vorspannen, in direktem Kontakt mit dieser Wand stehen.

7. Mikro-Reflektron nach Anspruch 6, wobei die zumindest zwei Elektroden (5210) in direktem Kontakt mit der Wand (5400) ihrerseits zumindest im Abstand über eine äußere Elektrode mittels eines Leitermaterialvolumens (3100, 3200) vorgespannt sind (3600), das zum Substrat gehört.

8. Mikro-Reflektron nach Anspruch 6 oder Anspruch 7, wobei die zumindest zwei Elektroden (7400) in direktem Kontakt mit der Wand (7500) von außerhalb des Reflektrons zugängliche Enden haben, wobei dieses von einer Haube (2100, 2200; 3100, 3200; 7000, 7300) bedeckt ist, wobei die zumindest zwei Elektroden zumindest über diese von außerhalb zugänglichen Enden vorgespannt sind.

9. Mikro-Reflektron nach einem der vorangehenden Ansprüche, wobei die Wand (2100, 2200; 5400; 7000, 7500) aus Titannitrid, aus amorphem Silizium, aus Polysilizium aus Germanium oder aus Metalloxid besteht.

10. Massenspektrometer mit einem Mikro-Reflektron nach einem der Mikro-Reflektronansprüche 1 bis 9, ferner enthaltend eine lonisierungsquelle (1100, 1200), die Ionen erzeugt, und eine Vorrichtung zur Injektion und Beschleunigung von Ionen zum Mikro-Reflektron, wobei diese Injektionsvorrichtung durch die Technik von mikro-elektromechanischen Systemen MEMS auf dem gleichen Substrat wie das Mikro-Reflektron erhalten worden ist.

11. Massenspektrometer nach Anspruch 10, wobei die Injektions- und Beschleunigungsvorrichtung so angeordnet ist, dass die Injektion von Ionen (1300) orthogonal zu deren Bewegungsbahn am Ausgang der Ionisierungsquelle der Ionen (1200) erfolgt.

12. Massenspektrometer nach Anspruch 10 oder Anspruch 11, wobei die Injektionsvorrichtung eine resistive Wand enthält, die über zumindest zwei Elektroden (2400, 2500) vorgespannt ist, die von der Wand durch ein Leitermaterialvolumen (2100, 2200) getrennt sind.

13. Massenspektrometer nach einem der Ansprüche 10 bis 12, ferner enthaltend einen Detektor (1600) am Ausgang des Mikro-Reflektrons, wobei die lonisierungsquelle (1100) und dieser Detektor mit der Technik von mikro-elektromechanischen Systemen auf einem gleichen Substrat ausgebildet sind.

14. Massenspektrometer nach einem der Ansprüche 10 bis 13, wobei die lonisierungsquelle durch volumenmäßiges Bearbeiten mit der Technik von mikro-elektromechanischen Systemen hergestellt ist und ein Elektronenanziehungsgitter und eine Einheit von Elektroden umfasst, die eine Ionisierungskammer bilden, welche gestattet, gebildete Ionen anzuziehen bzw. abzustoßen, wobei diese lonisierungsquelle auf dem gleichen Substrat wie das Mikro-Reflektron gebildet ist.

15. Verfahren zum Herstellen einen Mikro-Reflektrons nach einem der Ansprüche 1 bis 9, umfassend einen Schritt des Nassätzens (E1) bzw. des reaktiven lonentiefätzens (DRIE) (F1) eines Wafers eines Substrats (2100, 2200; 3100, 3200; 7000), um einen Kanal so zu bilden, dass zumindest ein Teil eines lonenflugbereichs (2300; 3300; 7700) gebildet wird, einen Schritt des Abscheidens (E2; F1') einer Schicht (5400; 7500) aus zumindest einem resistiven Material, beispielsweise durch Epitaxie, und aus einem Vorspannungselektroden bildenden Material, einen Schritt (E3, F2) des Versiegelns dieses Wafers mit einem weiteren Wafer des Substrats, so dass eine Röhre gebildet wird, welche den Flugbereich der Ionen (2300; 3300; 7700) definiert, deren Wand aus zumindest einem resistiven Material besteht und entlang welcher sich die Vorspannungselektroden erstrecken, wobei das Versiegeln vom Typ "direktes Bonden", eutektisches Bonden, anodisches Bonden oder Harzbonden ist.

## Claims

1. Micro-reflectron for time-of-flight mass spectrometer comprising a substrate (2100; 3100, 5300, 5400; 7300, 7400, 7500; 7000) and, integrated with the volume of the substrate, means (2100; 5400; 7500; 7000) for application of a potential gradient in a volume suitable for constituting a flight zone of ions (2300; 3300; 7700), **characterized in that** the substrate is composed of the assembly of two wafers, at least one of said wafers being provided by etching with a channel so as to form the flight zone in a tube, said means of application comprise at least two polarization electrodes (5210, 7400) extending along the tube and the tube having a wall of at least one resistive material that can be polarized between these electrodes so as to generate a continuous potential gradient, itself providing the function of reflectron, this flight zone, these electrodes and this wall being obtained by the technology of etching/deposition/assembly of microelectromechanical systems (MEMS) and this micro-reflectron having a thickness of less than 5 millimetres, while its other dimensions are less than 10 times this thickness.

2. Micro-reflectron according to claim 1, in which said wall comprises at least one layer of resistive material (5400; 7500) deposited on a surface of one of said wafers, said one of said wafers constituting a volume of the substrate (3100, 3200, 5300; 7300).

3. Micro-reflectron according to claim 2, in which the layer of resistive material (5400) is isolated from this volume of the substrate (3100, 3200) on a portion of its surface by an insulating material (5300).

4. Micro-reflectron according to claim 2 or claim 3, in which said volume of the substrate comprises an insulating material (7300).

5. Micro-reflectron according to claim 1, in which said wall comprises at least one surface portion of at least one of said wafers, said at least one of said wafers constituting a volume of the substrate (2100, 2200; 7000), the latter being of at least one resistive material.

6. Micro-reflectron according to any one of claims 1 to 5, in which the electrodes (5210; 7400) that polarize the wall (5400; 7500) of at least one resistive material are in direct contact with said wall.

7. Micro-reflectron according to claim 6, in which at least two electrodes (5210) in direct contact with said wall (5400) are themselves polarized (3600) at least at a distance, by an exterior electrode, via a volume of conductive material (3100, 3200) forming part of the substrate.

8. Micro-reflectron according to claim 6 or claim 7, in which at least two electrodes (7400) in direct contact with said wall (7500) have ends that are accessible from outside the reflectron, the latter being provided with a cover (2100, 2200; 3100, 3200; 7000, 7300), the at least two electrodes being polarized at least by these ends that are accessible from outside.

9. Micro-reflectron according to one of the preceding claims, in which said wall (2100, 2200; 5400; 7000, 7500) is of titanium nitride, amorphous silicon, polysilicon, germanium or metal oxide.

10. Mass spectrometer comprising a micro-reflectron according to any one of the micro-reflectron claims 1 to 9, additionally having an ionization source (1100, 1200) generating ions and a device for injection and acceleration of the ions towards the micro-reflectron, said injection device being obtained by microelectromechanical systems (MEMS) technology on the same substrate as the micro-reflectron.

11. Mass spectrometer according to claim 10, in which the injection and acceleration device is arranged in such a way that the injection of ions (1300) takes place orthogonally relative to their path at the exit of the ionization source of the ions (1200).

12. Mass spectrometer according to claim 10 or claim 11, in which the injection device comprises a resistive wall polarized by at least two electrodes (2400, 2500) separated from said wall by a volume of a conductive material (2100, 2200).

13. Mass spectrometer according to any one of claims 10 to 12, additionally having a detector (1600) at the exit of the micro-reflectron, and in which the ionization source (1100) and said detector are produced by the technology of microelectromechanical systems on one and the same substrate.

14. Mass spectrometer according to any one of claims 10 to 13, in which the ionization source is manufactured by volumetric machining in the technology of microelectromechanical systems, and comprises an electron attracting grid and an electrode assembly constituting an ionization chamber, for attracting or repelling ions that are formed, this ionization source being formed on the same substrate as the micro-reflectron.

15. Fabrication method for a micro-reflectron according to any one of claims 1 to 9, comprising a step of wet etching (E1) or of deep reactive ionic etching (DRIE) (F1) of a wafer of a substrate (2100, 2200; 3100, 3200; 7000) to form a channel so as to form at least a part of a flight zone of the ions (2300; 3300; 7700), a step of deposition (E2; F1') of a layer (5400; 7500) of at least one resistive material, for example by epitaxy, and of a material constituting polarization electrodes, and a step of sealing (E3, F2) of this wafer to another wafer of the substrate so as to form a tube defining said flight zone of the ions (2300; 3300; 7700) of which the wall is of at least one resistive material and along which extend the polarization electrodes, the sealing being of the "direct bonding" type, eutectic bonding, anodic bonding or gluing with resin.
